# FASCICULE DE BREVET EUROPEEN

(11) **EP 1 846 157 B1**
(45) Date de publication et mention de la délivrance du brevet: **13.12.2017**
(21) Numéro de dépôt: 06709240.3
(22) Date de dépôt: 03.02.2006
(51) Int. Cl.: B01J 35/10, B01J 35/02, B01J 37/02, B01J 23/745, C30B 7/00, C30B 29/60, C08K 3/04, C08K 7/24, B01J 8/24, B01J 21/04, B01J 35/00, B82Y 30/00, B82Y 40/00, C01B 32/162

(54) **PROCEDE DE SYNTHESE DE NANOTUBES DE CARBONE**
SYNTHESEVERFAHREN FÜR KOHLENSTOFFNANORÖHREN
METHOD FOR SYNTHESIS OF CARBON NANOTUBES

(30) Priorité: 07.02.2005 FR 0501197; 20.10.2005 FR 0510699; 24.10.2005 US 729650 P
(43) Date de publication de la demande: 24.10.2007
(73) Titulaire: ARKEMA FRANCE, 92700 Colombes (FR)
(72) Inventeur: BORDERE, Serge, F-64110 Jurancon (FR); COCHARD, Daniel, F-64300 Argagnon (FR); DUTILH, Eric, F-64170 Cescau (FR); GAILLARD, Patrice, F-64370 Hagetaubin (FR); PLEE, Dominique, F-64140 Lons (FR)
(86) Numéro de dépôt international: PCT/FR2006/000250
(87) Numéro de publication internationale: WO 2006/082325

(56) Documents cités:
- FR-A- 2 826 596
- MAURON P ET AL: "Fluidised-bed CVD synthesis of carbon nanotubes on Fe2O3/MgO" DIAMOND AND RELATED MATERIALS, ELSEVIER SCIENCE PUBLISHERS, AMSTERDAM, NL, vol. 12, no. 3-7, mars 2003 (2003-03), pages 780-785, XP004423758 ISSN: 0925-9635
- CORRIAS M ET AL: "Carbon nanotubes produced by fluidized bed catalytic CVD: first approach of the process" CHEMICAL ENGINEERING SCIENCE, OXFORD, GB, vol. 58, no. 19, octobre 2003 (2003-10), pages 4475-4482, XP004457064 ISSN: 0009-2509
- FAZLE KIBRIA A K M ET AL: "Synthesis of narrow-diameter carbon nanotubes from acetylene decomposition over an iron-nickel catalyst supported on alumina" CARBON, vol. 40, no. 8, juillet 2002 (2002-07), pages 1241-1247, XP004357621 ISSN: 0008-6223
- YU Z ET AL: "Catalytic engineering of carbon nanotube production" APPLIED CATALYSIS A: GENERAL, ELSEVIER SCIENCE, AMSTERDAM, NL, vol. 279, no. 1-2, 28 janvier 2005 (2005-01-28), pages 223-233, XP004718191 ISSN: 0926-860X
- PEREZ-CABERO M ET AL: "Syntheses of CNTs over several iron-supported catalysts: influence of the metallic precursors" CATALYSIS TODAY, ELSEVIER, vol. 93-95, 1 septembre 2004 (2004-09-01), pages 681-687, XP004549012 ISSN: 0920-5861
- NAVARRO LOPEZ P ET AL: "A study of carbon nanotube formation by C2H2 decomposition on an iron based catalyst using a pulsed method" CARBON, vol. 41, no. 13, 2003, pages 2509-2517, XP004458779 ISSN: 0008-6223

## Description

La présente invention a pour objet un procédé de synthèse de nanotubes de carbone (NTC) en phase gazeuse en présence d'un catalyseur métallique supporté par un substrat inorganique spécifique.

### Technique antérieure

Les nanotubes de carbone sont reconnus aujourd'hui comme des matériaux présentant de grands avantages, du fait de leurs propriétés mécaniques, de leurs rapports de forme (longueur/diamètre) très élevés ainsi que de leurs propriétés électriques.

Ils se composent de feuillets graphitiques enroulés terminés par des hémisphères constitués de pentagones et d'hexagones de structure proche des fullerènes.

On connaît des nanotubes composés d'un seul feuillet : on parle alors de SWNT (acronyme anglais de Single Wall Nanotubes) ou de nanotubes composés de plusieurs feuillets concentriques appelés alors MWNT (acronyme anglais de Multi Wall Nanotubes). Les SWNT sont en général plus difficiles à fabriquer que les MWNT.

La production des nanotubes de carbone peut être mise en oeuvre selon différents procédés comme la décharge électrique, l'ablation laser ou la déposition chimique en phase vapeur (CVD)

Parmi ces techniques, cette dernière semble être la seule susceptible de pouvoir assurer la fabrication en quantité importante de nanotubes de carbone, condition essentielle pour assurer un prix de revient permettant de déboucher massivement dans les applications polymères et résines.

Selon cette méthode, on injecte une source de carbone à température relativement élevée sur un catalyseur, ledit catalyseur pouvant être constitué d'un métal supporté sur un solide inorganique. Parmi les métaux, sont cités de manière préférentielle fer, cobalt, nickel, molybdène et parmi les supports, on retrouve souvent alumine, silice ou magnésie.

Les sources de carbone envisageables sont le méthane, l'éthane, l'éthylène, l'acétylène, l'éthanol, le méthanol, l'acétone, voire le gaz de synthèse CO + H₂ (procédé HIPCO).

Parmi les documents présentant la synthèse de nanotubes de carbone, on peut citer WO 86/03455A1 d'Hyperion Catalysis International Inc. correspondant à EP 225.556 B1 que l'on peut considérer comme l'un des brevets de base sur la synthèse des NTC qui revendique des fibrilles de carbone (ancienne dénomination des NTC) quasi cylindriques dont le diamètre est compris entre 3,5 et 70 nm, le rapport de forme supérieur ou égal à 100 ainsi que leur procédé de préparation

La synthèse se fait par mise en contact d'un catalyseur contenant du fer (par exemple Fe₃O₄, Fe sur un support de charbon, Fe sur un support d'alumine ou Fe sur un support en fibrille carbonée) avec un composé gazeux contenant du carbone (de préférence CO ou hydrocarbure(s)), avantageusement en présence d'un composé capable de réagir avec du carbone pour produire des produits gazeux, (par exemple CO, H₂ ou H₂O). Dans les exemples, les catalyseurs sont préparés par imprégnation à sec, par précipitation ou par imprégnation en voie humide.

WO 87/07559 correspondant à EP 270.666 B1 du même déposant revendique un procédé pour fabriquer des fibrilles de diamètre compris entre 3,5 et 70 nm mais de rapport de forme L/D compris entre 5 et 100, à partir des mêmes réactifs et catalyseurs.

Aucune information sur la productivité (qui serait exprimée comme la masse de fibrilles formées par gramme de catalyseur et par unité de temps) n'est donnée hormis le fait qu'il faut travailler, dans le cas où le composé gazeux contenant du carbone est le benzène, à plus de 800°C.

D'autres documents revendiquent des améliorations de procédé, telles que le lit fluidisé continu qui permet de contrôler l'état d'agrégation du catalyseur et des matériaux carbonés formés (voir par exemple WO 02/94713A1 au nom de l'Université de Tsinghua) ou des améliorations de produits tels WO 02/095097 A1 au nom de Trustees Of Boston College qui prépare des nanotubes de morphologie variée et non alignés, en jouant sur la nature du catalyseur et les conditions de réaction.

US 2001/0036549 A1 d'Hyperion Catalysis International Inc. décrit un procédé amélioré de préparation de NTC par décomposition d'une source de carbone en contact avec un métal de transition multivalent ou de préférence un mélange de métaux (tel que Fe et Mo, Cr, Mn et/ou Ce), dont l'amélioration consiste en ce que le métal de transition, formant une multiplicité de sites catalytiques de taille comprise entre 3,5 et 70 nm, est supporté par un substrat inorganique de taille inférieure à 400 µm.

Dans les exemples, la source de carbone est un mélange hydrogène/éthylène dont les pressions partielles respectives sont de 0,66 et 0,33, le temps de réaction à 650°C est de 30 minutes et le catalyseur est préparé par imprégnation d'une alumine de pyrolyse (taux de fer non donné, estimé à 15 %) avec du nitrate de fer en présence de méthanol en quantité suffisante pour obtenir une pâte ; la productivité est de 6,9 g/g en 30 minutes tandis qu'elle atteint entre 10,9 et 11,8 lorsque du sel de molybdène est ajouté, pour des taux de fer de l'ordre de 9 à 10% et de molybdène de 1 à 2 %. Quand le co-métal est le cérium, le chrome, le manganèse, la productivité en nanotubes est respectivement de 8,3, 9,7 et 11.

On constate aussi que l'acétylacétonate de fer est moins efficace que le nitrate de fer.

Dans l'exemple 16, l'imprégnation est faite en voie aqueuse par précipitation à pH sensiblement égal à 6 par ajout simultané de solutions de nitrate de fer et de bicarbonate de sodium. Le catalyseur conduit à une sélectivité de 10,5 pour un taux de fer de 15 % et une introduction en semi-continu dans le réacteur.

Un autre exemple par imprégnation en voie aqueuse de fer et de molybdène conduit à des résultats aussi bons que la voie méthanol.

Ce document montre aussi que le remplacement du fer par le molybdène à des teneurs supérieures à 2,5 % en Mo est plutôt défavorable puisqu'une productivité de 8,8 est atteinte en 30 minutes pour un mélange à proportions égales de Fe et Mo (total = 16,7%).

Lorsqu'on utilise un support non poreux tel que l'alumine de pyrolyse Degussa utilisée par Hyperion de surface spécifique = 100 m²/g, on constate qu'il est difficile d'imprégner de grandes quantités de fer car seule la couche externe est accessible au gaz et les couches inférieures n'auront pas d'action catalytique suffisante.

De plus, la technique utilisant ce genre de support est compliquée puisque la taille des particules est de 20 nm et la densité en vrac est de 0,06, ce qui augmente la difficulté de mise en oeuvre industrielle.

Ph. Mouron et al, dans Diamond and Related Materials 12 (2003) pp 780-785, décrivent la synthèse de NTC selon un procédé par CVD en lit fluidisé à partir d'acétylène ou d'iso-pentane comme source de carbone. Les catalyseurs étudiés sont préparés par mélange d'un substrat de type MgO (BET : 100 m2/g) avec une solution de nitrate de fer dans l'éthanolde façon à obtenir un précurseur qui est ensuite séché et broyé sous forme de poudre. La teneur massique en Fe dans les catalyseurs étudiés est toujours inférieure à 15%.

La présente invention a pour objet un procédé de synthèse de NTC par décomposition d'une source de carbone qui est mise en contact dans un réacteur, de préférence à lit fluidisé, à une température comprise entre 500 et 1.500 °C avec un ou plusieurs métaux de transition multivalents à un degré d'oxydation nul et/ou sous forme d'oxydes (degré d'oxydation positif) et récupération desdits NTC, caractérisé en ce que : le ou les métaux de transition et/ou leur(s) oxyde(s) sont supportés sur un substrat de surface spécifique BET supérieure à 50 m²/g, et, de préférence, comprise entre 70 m²/g et 300 m²/g choisi parmi les supports inorganiques, et de manière avantageuse les alumines de type gamma ou théta.
- la quantité de métal(aux) de transition représente de 15 à 50 % du poids du catalyseur final, et
- le catalyseur est préparé par imprégnation du substrat avec une solution d'imprégnation contenant au moins un sel de métal(aux) de transition, la quantité de solution d'imprégnation étant choisie pour qu'à tout moment, les particules de support soient en contact avec juste la quantité de solution nécessaire pour assurer la formation d'un film de surface sur lesdites particules de support.
- les particules de substrat ont un diamètre compris entre 20 et 500 µm.

Selon un mode de réalisation préféré, les supports sont susceptibles d'être imprégnés par une quantité de métal(aux) de transition et/ou d'oxyde(s) de métal(aux) de transition telle que la masse de métal (aux) de transition peut représenter de 30 à 40 % en poids du catalyseur final.

La taille des particules du support est choisie pour permettre une bonne fluidisation du catalyseur lors de la réaction de synthèse des NTC. Dans la pratique, pour assurer une productivité correcte, les particules de support οnt un diamètre compris au sens large entre environ 20 et environ 500 µm. Bien entendu, on ne sortirait pas du cadre de l'invention si la taille des particules du support était hors des limites indiquées précédemment.

L'imprégnation des particules de support est avantageusement mise en oeuvre sous balayage de gaz sec, par exemple au moyen d'une solution aqueuse de nitrate de fer lorsque le métal de transition est le fer, à une température comprise entre la température ambiante et la température d'ébullition de la solution ; selon l'invention, on choisit la quantité de solution d'imprégnation pour qu'à à tout moment, les particules de support soient en contact avec une quantité de solution suffisante pour assurer la formation d'un film de surface sur lesdites particules de support.

Le fait de travailler «à sec», c'est-à-dire en ayant à tout moment juste la quantité de liquide nécessaire pour créer un film liquide en surface des particules de support catalytique est un avantage car cela permet, en chauffant sous balayage d'air sec, d'éviter les rejets aqueux (par exemple les rejets aqueux de nitrates lorsque la solution d'imprégnation contient du nitrate de fer ; après imprégnation, le produit obtenu, est chauffé vers 300°C sous gaz inerte ou non pour éliminer les nitrates)

Selon un mode de réalisation préféré, la réduction du catalyseur s'opère in-situ dans le réacteur de synthèse, avantageusement en lit fluidisé, et le catalyseur ne revoit pas l'air et ainsi, le ou les métaux de transition, de préférence le fer reste sous forme métal.

Dans le cas d'une synthèse de NTC en continu avec un catalyseur sous forme d'oxyde(s) métallique(s), de préférence sous forme d'oxyde de fer, le catalyseur peut être injecté directement dans le milieu réactionnel sans passer par une étape de réduction. On évite ainsi avantageusement l'installation d'un réacteur de réduction et/ou le stockage du catalyseur sous forme réduite qui devrait être réalisé sous gaz inerte.

La source de carbone peut être choisie parmi tout type de matériau carboné tel que méthane, éthane, propane, butane, autre alcane aliphatique supérieur, benzène, cyclohexane, éthylène, propylène, butène, isobutène, autre alcène aliphatique supérieur, toluène, xylène, cumène, éthyl benzène, naphtalène, phénanthrène, anthracène, acétylène et alcyne supérieur, formaldéhyde, acétaldéhyde, acétone, méthanol, éthanol, monoxyde de carbone, etc., seuls ou en mélange.

Les NTC obtenus selon le procédé décrit ci-dessus peuvent être utilisés dans de nombreux domaines, notamment en électronique (selon la température et leur structure, ils peuvent être conducteurs, semi-conducteurs ou isolants), en mécanique, par exemple pour le renfort des matériaux composites (les NTC sont cent fois plus résistants et six fois plus légers que l'acier) et électromécanique (ils peuvent s'allonger ou se contracter par injection de charge) On peut par exemple citer l'utilisation de NTC dans des compositions macromoléculaires destinées par exemple à l'emballage de composants électroniques, à la fabrication de conduites d'essence (fuel line), de revêtements ou coating antistatiques, dans des thermistors, des électrodes pour supercapacités, etc.

### Exemple 1

On prépare un catalyseur à partir d'alumine gamma Puralox NWA 155 dont moins de 5 % en poids des particules sont inférieures à 100 µm et moins de 2 % sont supérieures à 500 µm et dont le diamètre médian est de l'ordre de 250 µm. Les caractéristiques de surface et porosité sont indiquées ci-dessous:

| | |
|---|---|
| Surface BET (m²/g) | 154 |
| Volume poreux total (cm³/g) | 0,45 (pores de 0 à 200 nm mesuré par DFT) |
| Volume des micropores (cm³/g) | 0,005 (pores de 0 à 2 nm mesuré par t-plot) |

Dans un réacteur de 3 L muni d'une double enveloppe chauffé à 100 °C, on introduit 300 g d'alumine et on balaye à l'air. Au moyen d'une pompe, on injecte alors en continu 700 ml d'une solution de fer contenant 545 g/l de nitrate de fer nonahydrate. Le ratio visé (masse de métal / masse de catalyseur) étant de 15 % en fer métal, la durée d'addition de la solution de fer est de 10 h et la vitesse d'ajout du liquide est égale à la vitesse d'évaporation de l'eau.

Le catalyseur est ensuite laissé à 100 °C en étuve pendant 16 h.

### Exemple 2

On prépare un catalyseur à partir d'alumine gamma Puralox SCCA 5-150 de diamètre médian égal à environ 85 µm.

Les caractéristiques de surface et porosité sont indiquées ci-dessous :

| | |
|---|---|
| Surface BET (m²/g) | 148 |
| Volume poreux total (cm³/g) | 0,47 (pores de 0 à 200 nm mesuré par DFT) |
| Volume micropores (cm³/g) | 0,0036 (pores de 0 à 2 nm mesuré par t-plot) |

La préparation du catalyseur et l'imprégnation sont faites de la même manière qu'à l'exemple 1.

### Exemple 3

On prépare un catalyseur à 25 % de fer par imprégnation dans des conditions proches de celles de l'exemple 2 avec la même alumine SCCA 5-150: la durée d'addition et le volume de solution sont simplement ajustés au prorata de la teneur en fer que l'on cherche à fixer, soit 16h.

Le catalyseur est ensuite laissé à 100 °C en étuve pendant 16h.

### Exemple 4

On prépare un catalyseur à 35 % de fer par imprégnation de l'alumine SCCA 5-150. La durée d'addition et le volume de solution sont simplement ajustés au prorata de la teneur en fer que l'on cherche à fixer, soit 23h.

Le catalyseur est ensuite laissé à 100°C en étuve pendant 16h.

### Exemple 5

On prépare un catalyseur à 50 % de fer par imprégnation de l'alumine SCCA 5-150. La durée d'addition et le volume de solution sont simplement ajustés au prorata de la teneur en fer que l'on cherche à fixer, soit 32h.

Le catalyseur est laissé à 100°C en étuve pendant 16h.

### Exemple 6

On prépare un catalyseur à partir d'alumine gamma C 500-511 d'Engelhard de diamètre médian 150 µm. Les caractéristiques de surface et porosité sont indiquées ci-dessous :

| | |
|---|---|
| Surface BET (m²/g) | 206 |
| Volume poreux total (cm³/g) | 0,48 (pores de 0 à 200 nm mesuré par DFT) |
| Volume micropores (cm³/g) | 0 (pores de 0 à 2 nm mesuré par t-plot) |

On prépare un catalyseur à 25 % de fer en utilisant les conditions de l'exemple 3. Le catalyseur est laissé à 100 °C pendant 16 h.

### Exemple 7

On prépare un catalyseur à partir d'alumine théta C 500-512 d'Engelhard de diamètre médian 70 µm.

Les caractéristiques de surface et porosité sont indiquées ci-dessous

| | |
|---|---|
| S BET (m²/g) | 93 |
| Volume poreux total (cm³/g) | 0,37 (pores de 0 à 200 nm mesuré par DFT) |
| Volume micropores (cm³/g) | 0,003 (pores de 0 à 2 nm mesuré par t-plot) |

On prépare un catalyseur à 25 % de fer par imprégnation dans les mêmes conditions qu'à l'exemple 3.

### Exemple 8

On pratique un test catalytique en mettant une masse d'environ 150 g de catalyseur en couche dans un réacteur de 25 cm de diamètre et 1 m de hauteur efficace, équipé d'un désengagement destiné à éviter l'entraînement de fines particules vers l'aval. On chauffe à 300 °C sous azote pour décomposer les nitrates, puis on monte sous hydrogène et azote (20%/80% vol./vol.) jusqu'à 650 °C. A cette température, on met un débit d'éthylène de 3000 NL/h et un débit d'hydrogène de 1000 NL/h, ce qui correspond à une pression partielle en éthylène de 0,75.

Le débit gazeux est suffisant pour que le solide soit largement au-delà de la vitesse limite de fluidisation, tout en restant en dessous de la vitesse d'envolement.

Après 60 minutes, on arrête la chauffe et on évalue le résultat de la quantité de produit formé. Parallèlement, une estimation de la qualité des nanotubes produits est faite par microscopie (type de NTC formé : SWNT ou MWNT; . Ø ; présence d'autres formes de C)

Les résultats sont réunis dans le tableau ci-dessous :

| Catalyseur de l'exemple | Productivité | Type de NTC formé |
|---|---|---|
| 1 | 6,6 | MWNT / Ø : 10-30 nm pas d'autres formes de C |
| 2 | 8 | MWNT / Ø : 10-30 nm pas d'autres formes de C |
| 3 | 11,4 | MWNT / Ø : 10-30 nm pas d'autres formes de C |
| 4 | 20 | MWNT / Ø : 10-30 nm pas d'autres formes de C |
| 5 | 15 | MWNT / Ø : 10-30 nm pas d'autres formes de C |
| 6 | 10 | MWNT / Ø : 10-30 nm pas d'autres formes de C |
| 7 | 9 | MWNT / Ø : 10-30 nm pas d'autres formes de C |

A titre comparatif, l'exemple 10 de US 2001/0036549 décrit la synthèse de NTC à partir d'un mélange hydrogène/éthylène en contact avec un catalyseur à 12 % en fer préparé à partir d'alumine de pyrolyse imprégnée avec du nitrate de fer ; la productivité en NTC est de 5,5 pour un catalyseur en 30 minutes.

### Exemple 9

Un catalyseur préparé selon l'exemple 4 est introduit dans un réacteur selon l'exemple 8 et est chauffé à 300°C pour décomposer les nitrates. On refroidit le réacteur et on récupère le catalyseur à l'air. Ce catalyseur qui n'a pas subi d'étape de réduction qui est donc sous forme d'oxyde de fer est alors réintroduit dans le réacteur chauffé à 650°C selon l'exemple 8 directement dans un flux d'éthylène et hydrogène avec une pression partielle d'éthylène de 0,8. Après 60 min de réaction, on arrête la chauffe et on évalue le résultat de la quantité et de la qualité du produit formé. On obtient une productivité de 14,6 comparable aux résultats obtenus avec un catalyseur réduit; les NTC formés sont de type MWNT / Ø : 10-30 nm et ne contiennent pas d'autres formes de carbone.

## Revendications

1. Procédé de synthèse de NTC par décomposition d'une source de carbone mise en contact dans un réacteur à lit fluidisé, à une température comprise entre 500 et 1500 °C avec un ou plusieurs métaux de transition multivalents à un degré d'oxydation nul et/ou sous forme d'oxydes (degré d'oxydation positif) et récupération desdits NTC, **caractérisé en ce que** :
- le ou les métaux de transition et/ou leur(s) oxyde(s) sont supportés sur un substrat de surface spécifique BET comprise entre 70 m²/g et 300 m²/g, choisi parmi les supports inorganiques,
- la quantité de métal(aux) de transition représente de 15 à 50 % du poids du catalyseur final, et
- le catalyseur est préparé par imprégnation du substrat avec une solution d'imprégnation contenant au moins un sel de métal(aux) de transition, la quantité de solution d'imprégnation étant choisie pour qu'à tout moment, les particules de support soient en contact avec juste la quantité de solution nécessaire pour assurer la formation d'un film de surface sur lesdites particules de support.
- les particules de substrat ont un diamètre compris entre 20 et 500 µm.

2. Procédé selon la revendication 1 **caractérisé en ce que** le support inorganique est choisi parmi les alumines de type gamme ou thêta.

3. Procédé selon la revendication 1 ou 2, **caractérisé en ce que** la quantité de métal(aux) de transition représente de 30 à 40 % du poids du catalyseur final.

4. Procédé selon l'une quelconque des revendications précédentes, **caractérisé en ce que** le catalyseur est sous balayage de gaz sec.

5. Procédé selon l'une des revendications précédentes, **caractérisé en ce qu'**il met en oeuvre un catalyseur de fer.

6. Procédé selon la revendication 5 mettant en oeuvre un catalyseur à base de fer, **caractérisé en ce que** ledit catalyseur est préparé par imprégnation du substrat au moyen d'une solution aqueuse de nitrate de fer, de préférence à une température comprise entre la température ambiante et la température d'ébullition de la solution d'imprégnation.

7. Procédé selon l'une des revendications précédentes, **caractérisé en ce qu'**il est continu.

8. Procédé selon l'une des revendications précédentes, **caractérisé en ce que** le catalyseur est à base d'oxyde(s) métallique(s), de préférence d'oxyde de fer.

## Patentansprüche

1. Syntheseverfahren für Kohlenstoffnanoröhren durch Zersetzen einer Kohlenstoffquelle, die in einem Flüssigbettreaktor bei einer Temperatur zwischen 500 und 1500 °C mit einem oder mehreren mehrwertigen Übergangsmetallen mit einer Oxidationszahl null und/oder in Form von Oxiden (positive Oxidationszahl) in Kontakt gebracht wird, und Gewinnen der Kohlenstoffnanoröhren, **dadurch gekennzeichnet, dass**:
- das oder die Übergangsmetall(e) und/oder sein bzw. ihre Oxid(e) auf einem Substrat mit einer spezifischen BET-Oberfläche zwischen 70 m²/g und 300 m²/g angeordnet wird bzw. werden, das aus anorganischen Trägern ausgewählt wird,
- die Menge an Übergangsmetall(en) 15 bis 50 % des Gewichts des endgültigen Katalysators ausmacht, und
- der Katalysator durch Tränken des Substrats mit einer Tränklösung hergestellt wird, die mindestens ein Salz von (einem) Übergangsmetall(en) enthält, wobei die Menge der Tränklösung so gewählt wird, dass die Trägerpartikel jederzeit Kontakt zu genau der erforderlichen Lösungsmenge haben, dass die Bildung eines Oberflächenfilms auf den Trägerpartikeln gewährleistet ist,
- die Substratpartikel einen Durchmesser zwischen 20 und 500 µm aufweisen.

2. Verfahren nach Anspruch 1, **dadurch gekennzeichnet, dass** der anorganische Träger aus gamma- oder theta-Aluminiumoxid ausgewählt wird.

3. Verfahren nach Anspruch 1 oder 2, **dadurch gekennzeichnet, dass** die Menge an Übergangsmetall(en) 30 bis 40 % des Gewichts des endgültigen Katalysators ausmacht.

4. Verfahren nach einem der vorhergehenden Ansprüche, **dadurch gekennzeichnet, dass** der Katalysator mit trockenem Gas gespült wird.

5. Verfahren nach einem der vorhergehenden Ansprüche, **dadurch gekennzeichnet, dass** dabei ein Eisenkatalysator verwendet wird.

6. Verfahren nach Anspruch 5, bei dem ein Katalysator auf Eisenbasis verwendet wird, **dadurch gekennzeichnet, dass** der Katalysator, vorzugsweise bei einer Temperatur zwischen der Umgebungstemperatur und der Siedetemperatur der Tränklösung, durch Tränken des Substrats mit einer wässrigen Eisennitratlösung hergestellt wird.

7. Verfahren nach einem der vorhergehenden Ansprüche, **dadurch gekennzeichnet, dass** es kontinuierlich ist.

8. Verfahren nach einem der vorhergehenden Ansprüche, **dadurch gekennzeichnet, dass** der Katalysator auf Metalloxid(en), vorzugsweise Eisenoxid, basiert.

## Claims

1. Process for synthesizing CNTs by decomposition of a carbon source that is brought into contact in a fluidized-bed reactor, at a temperature of between 500°C and 1500°C, with one or more multivalent transition metals with a zero oxidation state and/or in oxide form (positive oxidation state) and recovery of said CNTs, **characterized in that**:
- the transition metal or metals and/or their oxide(s) are supported on a substrate with a BET specific surface area of between 70 m²/g and 300 m²/g, chosen from inorganic supports,
- the amount of transition metal(s) represents from 15% to 50% of the weight of the final catalyst,
- the catalyst is prepared by impregnating the substrate with an impregnation solution containing at least one salt of transition metal (s), the amount of impregnation solution being chosen so that, at any moment, the support particles are in contact with exactly the amount of solution needed to ensure the formation of a surface film on said support particles,
- the substrate particles have a diameter of between 20 and 500 µm.

2. Process according to Claim 1, **characterized in that** the inorganic support is chosen from gamma-type or theta-type aluminas.

3. Process according to Claim 1 or 2, **characterized in that** the amount of transition metal(s) represents from 30% to 40% of the weight of the final catalyst.

4. Process according to any one of the preceding claims, **characterized in that** the catalyst is under a stream of dry gas.

5. Process according to one of the preceding claims, **characterized in that** it uses an iron catalyst.

6. Process according to Claim 5 using an iron-based catalyst, **characterized in that** said catalyst is prepared by impregnating the substrate by means of an aqueous iron nitrate solution, preferably at a temperature between room temperature and the boiling point of the impregnation solution.

7. Process according to one of the preceding claims, **characterized in that** it is continuous.

8. Process according to one of the preceding claims, **characterized in that** the catalyst is based on metal oxide(s), preferably on iron oxide.
